(19) Europäisches Patentamt
European Patent Office
Office européen des brevets

(11) **EP 4 528 946 A1**

(12) **EUROPEAN PATENT APPLICATION**

(43) Date of publication:
**26.03.2025 Bulletin 2025/13**

(21) Application number: **24186974.2**

(22) Date of filing: **06.07.2024**

(51) International Patent Classification (IPC):
***H01S 5/183*** (2006.01)    ***H01S 5/024*** (2006.01)
***H01S 5/042*** (2006.01)

(52) Cooperative Patent Classification (CPC):
**H01S 5/02461; H01S 5/04256; H01S 5/18311;
H01S 5/18341;** H01S 5/04252; H01S 5/04254;
H01S 5/04257; H01S 5/18347

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **22.09.2023 EP 23199013**

(71) Applicant: **Changchun Institute of Optics, Fine
Mechanics and
Physics, Chinese Academy of Sciences
Jilin 130033 (CN)**

(72) Inventors:
• **TIAN, Sicong**
**Changchun Jilin, 130033 (CN)**
• **BIMBERG, Dieter**
**14089 Berlin (DE)**
• **MOHAMMED ALTHOF MARICAR, Mansoor
Ahamed**
**Changchun, Jilin, 130033 (CN)**

(74) Representative: **Fischer, Uwe
Patentanwalt
Moritzstraße 22
13597 Berlin (DE)**

(54) **RADIATION EMITTER AND METHOD OF FABRICATING RADIATION EMITTERS**

(57)     An exemplary embodiment of the invention relates to a method of fabricating a radiation emitter (100) comprising the steps of fabricating a lower layer stack (20) on top of a substrate (10), the lower layer stack (20) comprising a lower contact layer (21) and at least one lower reflector (22), fabricating an intermediate layer stack (30) on top of the lower layer stack (20), the intermediate layer stack (30) comprising at least one active layer (31) and at least one aperture layer (32), fabricating an upper layer stack (40) on top of the intermediate layer stack (30), the upper layer stack (40) comprising at least one upper reflector (42) and an upper contact layer (41), and forming a mesa that at least comprises a mesa section of the upper layer stack (40), by locally removing at least the upper layer stack (40). After or before forming the mesa, at least one blind hole (60) having a depth (D) smaller than the thickness (T) of the upper layer stack (40) is etched inside the mesa section of the upper layer stack (40), and the at least one blind hole (60) is filled with a thermally conductive material (70).

Fig.12

EP 4 528 946 A1

**Description**

Background of the invention

Vertical Cavity Surface Emitting Lasers (VCSELs) and Edge Emitting Lasers (EELs) are key devices for a rapidly increasing spectrum of systems. It is known, that VCSELs are the dominating light sources for short and medium reach interconnects in workstation clusters or supercomputers due to their large bitrate in concert with a small energy consumption per bit. Both parameters - increase of bitrate and energy consumption (defined by energy to data ratio EDR) - are presently the subjects of large progress. There exists a trade-off between these parameters. The EDR increases rapidly with increasing bit rate. The optimal properties of a VCSEL for a given system thus depends on its bitrate [Larisch et al. Optics Express 28, 6, 2020).

There is large demand for increasing the capacity of given or future work station clusters by further increasing the bit rates of their optical interconnects, in particular the light emitting VCSELs. Their bit rates increase with the square root of the drive current. Increasing this current is limited by the saturation of the output power at a given saturation current, beyond that the output power decreases. This saturation is a result of heating of the active area of the device, shifting its wavelength of emission out of resonance with the narrow transmission curve of the output mirror, consisting typically of a Bragg reflector.

The workload of a workstation cluster or a supercomputer is volatile. Processors are rapidly adapting their performance and energy consumption depending on actual demand. State-of-the-art processors have different cores for different workloads. The operating parameters of a present VCSEL, being the light source of an active optical cable connecting work stations to each other however, cannot be adapted to the varying workload of e.g. a network, a work station cluster,... and is thus operating typically under non-optimum conditions, like larger energy or cooling water consumption than necessary.

Known in the art are radiation emitters with electrically non-conductive reflectors and radiation emitters with electrically conductive reflectors. These two types of radiation emitters are based on different fabrication techniques in connection with different material systems.

Radiation emitters with electrically non-conductive reflectors and filled holes to contact buried electrical layers are described for instance in US 2010/0215070 A1, US 2022/311212 A1 and US 2020/274328 A1.

Methods of fabricating radiation emitters according to the preamble of claim 1 are known in the art in connection with the fabrication of VCSELs and EELs that comprise electrically conductive reflectors.

Objective of the present invention

In view of the above, an objective of the present invention is to propose a radiation emitter with improved thermal characteristic.

A further objective of the present invention is to provide a method for fabricating a radiation emitter that shows an optimized thermal characteristic.

Brief summary of the invention

An exemplary embodiment of the present invention relates to a method according to claim 1.

An advantage of this embodiment of the invention is, that the at least one blind hole filled with a thermally conductive material provides a thermal bypass that reduces the thermal resistance of the upper layer stack and thus reduces the temperature of the active light emitting area of the radiation emitter. For instance, heat that is generated inside the active layer by nonradiative recombination or by series resistance in the device, may use the bypass to pass through the upper portion of the upper layer stack in order to reach the outer surface of the radiation emitter, thereby providing an optimized heat transfer compared to radiation emitters without such thermal bypasses. As such, the method according the present invention allows for instance fabricating Surface Emitting lasers (or VCSELs) or Edge Emitting lasers (EEL) with large heat conductivity. Further, for instance, it is possible to increase the possible light output power and the bit rate, by reducing the temperature of the active area for a given current and thus increasing the saturation current.

Another advantage is that the operating temperature range is increased compared to emitters without filled blind holes.

Since the upper reflector is electrically conductive, the upper reflector can be subjected to electrical current flow during operation of the radiation emitter.

Since the blind holes vertically end in the upper layer stack and therefore above all active layers and above all aperture layers of the radiation emitter, the active and aperture layers remain unaffected by the thermal bypasses. In other words, all active layers and all aperture layers are located in the intermediate layer stack and therefore exclusively below the upper layer stack to make sure that the filled blind holes (i.e. the bypasses) do not interact with the active layer(s) and the aperture layer(s).

Suitable thermally conductive materials are for instance metals such as Gold, Silver, Platinum, Titanium and Nickel, alloys of such metals, electrically isolating materials such as glass or ceramics, electrically conductive polymers, or electrically conductive oxides, preferably transparent electrically conductive oxides, such as indium tin oxide (ITO), fluorine doped tin oxide (FTO), aluminium doped zinc oxide (AZO), carbon or carbon nanotubes.

The thermal conductivity of the thermally conductive material preferably exceeds 200 W/(K·m) at a temperature of 300 K.

Preferably, all layers of the upper layer stack, the intermediate layer stack and the lower layer stack are electrically conductive and can be subjected to electrical current during operation of the radiation emitter.

If the blind holes are filled with an electrical isolator, the electrical current needs to flow through the upper layer stack and therefore through the upper reflector. In order to avoid excessive electrical losses, the electrical resistivity, also referred to as specific resistance, of the upper layer stack (in vertical direction and bias current related) should therefore be below a maximum value of $10^5$ $\Omega$cm. Preferably, each layer of the upper layer stack (including the layers of the upper reflector) has an electrical resistivity (in vertical direction) below $10^5$ $\Omega$cm.

If the blind holes are filled with a thermally and electrically conductive material, the electrical resistance of the upper layer stack and therefore the heat production are also reduced and thereby the performance of the resulting radiation emitter may be further improved. In the latter case, the filled blind holes form both electrical and thermal bypasses.

The filled blind holes preferably terminate below the upper reflector and above the intermediate layer stack, for instance directly above the intermediate layer stack, and therefore vertically extend through the entire upper reflector, such that heat, and in case of electrically conductive bypasses also the electrical current, can bypass the upper reflector.

In order to achieve an optimal distribution of the electrical current density (e. g. bias current density) above and inside the aperture (in case of more than one aperture, the uppermost aperture) during operation of the radiation emitter, the electrical current (e. g. bias current) preferably flows through both a first (vertical) electrical path, that is formed by the upper reflector, and a second (vertical) electrical path (hereinafter referred to as "bypass") that is formed by the filled hole(s). Preferably, at least 20% of the total electrical bias current vertically flows along the first path and maximal 80% of the total electrical bias current vertically flows through the second electrical path ("bypass"). Here, the total electrical current results from the sum of the (first) electrical current that flows along the first electrical path and the (second) electrical current that flows along the second electrical path.

To achieve a minimum current flow of 20% through the upper reflector, the electrical specific resistance (in vertical direction) of the upper reflector should be below $10^5$ $\Omega$cm. Preferably, each layer of the upper layer stack (including the layers of the upper reflector) has an electrical resistivity below $10^5$ $\Omega$cm.

The lower layer stack, the intermediate layer stack and the upper layer stack preferably consist of materials of the following material systems:

- GaAs-based material systems, like GaAs, AlGaAs, GaInAsP, GaInN, ...
- InP-based material systems, like InP, InGaAs, InGaAsP, InGaAlAsP, ...
- GaN-based material systems, like GaN, AlGaN, InGaN, InGaAlN, ...

The wafers on which the layer stacks are grown preferably include

- GaAs or Si for the GaAs-based material systems,
- InP or Si for the InP-based material systems, and
- GaN, SiC, Si, AlN, for the GaN-based material systems.

The above specified minimum value for the electrical conductivities can be achieved by providing n- or p-doping concentrations of at least $10^{17}$ cm$^{-3}$.

The at least one hole may be ring-shaped. The ring-shaped hole may have any closed contour such as a circular, elliptical, triangular, square, rectangular or polygonal contour. However, a circular or an elliptical contour are preferred.

A circularly ring-shaped hole may be chosen for instance if the radiation emitter is intended to be polarization-independent.

In a top view, the distance between an inner wall of the circularly ring-shaped hole and the outer edge of the aperture preferably lies within a range of 1,5 $\mu$m to 20 $\mu$m in order to optimize the distribution of the current density.

The radial width (or thickness) of the circularly ring-shaped hole preferably lies within a range of 2 $\mu$m to 10 $\mu$m.

An elliptically ring-shaped hole may be chosen if the radiation emitter is intended to be polarization-dependent. In case that the elliptically ring-shaped hole is filled with an electrically conductive material, the elliptically ring-shaped hole forms a thermal bypass and an electrical bypass and in addition controls the polarization of the emitted radiation.

The quotient between the width parameter a and the height parameter b, the so-called semi-major and semi-minor axes, of the elliptically ring-shaped hole preferably fulfil the following condition:

$$1,2 < a/b < 3,0$$

If this condition is met, the main polarization is usually at least 50% greater than any other polarization, particularly the polarization perpendicular to the main polarization.

In a top view, the minimum distance between an inner wall of the elliptically ring-shaped hole and the outer edge of the aperture preferably exceeds 1,5 $\mu$m and preferably lies within a range of 1,5 $\mu$m to 20 $\mu$m.

The radial width (thickness of the ring) of the elliptically ring-shaped hole preferably lies within 2 $\mu$m and 10 $\mu$m.

The lower contact layer is preferably provided with a lower contact material to form a lower electric contact of the radiation emitter, and the upper contact layer is preferably provided with an upper contact material to form an upper contact of the radiation emitter.

The step of filling the at least one blind hole with the thermally conductive material and the step of providing the upper contact layer with the upper contact material may be independent steps, wherein the step of providing the upper contact layer with the upper contact material is preferably carried out after the step of filling the at least one blind hole with the thermally conductive material.

The upper contact material and the thermally conductive material may be different materials.

Alternatively, the upper contact material and the thermally conductive material can be the same material.

The step of filling the at least one blind hole with the thermally conductive material and the step of providing the upper contact layer with the upper contact material may alternatively be carried out in a single contacting step, for instance a single metallization step. In the latter case, the upper contact material and the thermally conductive material are preferably the same material.

After forming the mesa, the at least one aperture layer is preferably subjected to a lateral oxidation step to provide an unoxidized aperture that is laterally surrounded by oxidized material.

Alternatively, the aperture layer may be laterally oxidized to form one or more apertures before forming the mesa. The lateral oxidation may for instance be carried out through oxidation holes that are deeper than said blind holes and vertically extend to the aperture layer, as for instance described in the European Patent publications EP 3 961 829 A1, EP 3 961 830 A1, and EP 4 007 092 B1.

The at least one blind hole may be etched and filled with the thermally conductive material after forming the mesa. In this case, the at least one blind hole is preferably filled with the thermally conductive material before laterally oxidizing the aperture layer in order to protect the interior wall of the blind holes from the oxidation process.

Alternatively, the at least one blind hole may be etched after laterally oxidizing the aperture layer.

The at least one blind hole may also be etched before forming the mesa. In the latter case, the at least one blind hole is preferably filled with the thermally conductive material before laterally oxidizing the aperture layer.

Said step of forming the mesa preferably includes removing the intermediate layer stack or at least an upper portion of the intermediate layer stack, wherein the upper portion of the intermediate layer stack comprises the at least one aperture layer.

The size, i.e. diameter of the mesa, is preferably in the range of 10 to 100 $\mu$m. The size of the mesa is preferably adapted to the typical diameter (50 $\mu$m or 62,5 $\mu$m) of the core of a standard multimode fiber and butt-coupling between a standard multimode fiber and the mesa is possible.

The radiation emitter preferably forms a vertical emitting laser (VCSEL).

The mesa may have steps.

Another exemplary embodiment of the present invention relates to a radiation emitter according to claim 11. The radiation emitter is preferably fabricated as outlined above.

The at least one hole may be circularly ring-shaped or elliptically ring-shaped.

Moreover, a plurality of filled blind holes that each or together form the above mentioned bypass and have a depth smaller than the thickness of the upper layer stack, may be located inside the upper layer stack of the mesa.

## Brief description of the drawings

In order that the manner, in which the above-recited and other advantages of the invention are obtained, will be readily understood, a more particular description of the invention briefly described above will be rendered by reference to specific embodiments thereof, which are illustrated in the appended figures. Understanding that these figures depict only typical embodiments of the invention and are therefore not to be considered limiting its scope, the invention will be described and explained with additional specificity and detail by the use of the accompanying drawings in which

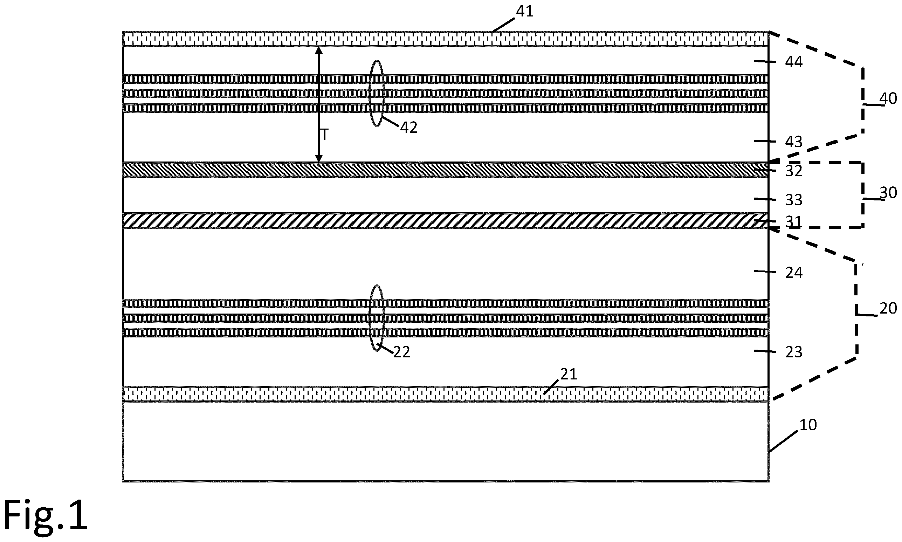

Figures 1-6       illustrate method steps of a first exemplary embodiment of a method of fabricating a radiation emitter according to the present invention,

| Figures 7-12 | illustrate method steps of a second exemplary embodiment of a method of fabricating a radiation emitter according to the present invention, |
|---|---|
| Figures 13-14 | illustrate method steps of a third and fourth exemplary embodiment of a method of fabricating a radiation emitter according to the present invention, |
| Figures 15-16 | illustrate method steps of a fifth exemplary embodiment of a method of fabricating a radiation emitter according to the present invention, |
| Figure 17 | illustrates an exemplary embodiment of a radiation emitter having a single circularly ring-shaped hole that is filled with electrically and thermally conductive material, and |
| Figure 18 | illustrates an exemplary embodiment of a radiation emitter having a single elliptically ring-shaped hole that is filled with electrically and thermally conductive material. |

## Detailed description of the preferred embodiments

The preferred embodiments of the present invention will be best understood by reference to the drawings, wherein identical or comparable parts are designated by the same reference signs throughout.

It will be readily understood that the parameters of the embodiments of the present invention, as generally described herein, could vary in a wide range. Thus, the following more detailed description of exemplary embodiments of the present invention, is not intended to limit the scope of the invention but is merely representative of presently preferred embodiments of the invention.

Figures 1-6 depict a first exemplary embodiment of a method of fabricating a radiation emitter according to the present invention.

Figure 1 shows a substrate 10 on which a lower layer stack 20, an intermediate layer stack 30 and an upper layer stack 40 have been fabricated. The layers of the layer stacks may be deposited by chemical vapour deposition or molecular beam epitaxy or similar thin layer deposition methods as known in the art.

The lower layer stack 20 is formed on top of the substrate 10 and comprises a lower contact layer 21, a lower reflector 22, and an additional layer 23. The additional layer 23 separates the lower reflector 22 from the lower contact layer 21. The lower layer stack 20 may comprise further layers. Such further layers may separate the lower reflector 22 from the intermediate layer stack 30. In Figure 1, such a further layer is designated by reference number 24. The lower layer stack 20 including the lower reflector 22 is electrically conductive and subjected to electrical current (e.g. bias current) during operation.

The intermediate layer stack 30 is formed on top of the lower layer stack 20 and comprises an active layer 31, an aperture layer 32 and an intermediate layer 33 which separates the active layer 31 from the aperture layer 32. The intermediate layer stack 30 may comprise further layers which are not shown in Figure 1. Such further layers may separate the active layer 31 and/or the aperture layer 32 from the upper and/or lower layer stack. The active layer 31 may be above or below the aperture layer 32. Furthermore, there may be one or more aperture layers above the active layer and/or one or more aperture layers below the active layer.

The upper layer stack 40 is formed on top of the intermediate layer stack 30 and comprises an upper contact layer 41, an upper reflector 42, and additional layers 43 und 44. The additional layers 43 and 44 separate the upper reflector 42 from the intermediate layer stack 30 and the upper reflector 42 from the upper contact layer 41, respectively. The upper layer stack 40 may comprise further additional layers. The upper layer stack 40 including the upper reflector 42 is electrically conductive and can conduct electrical current (e.g. bias current) during operation of the radiation emitter.

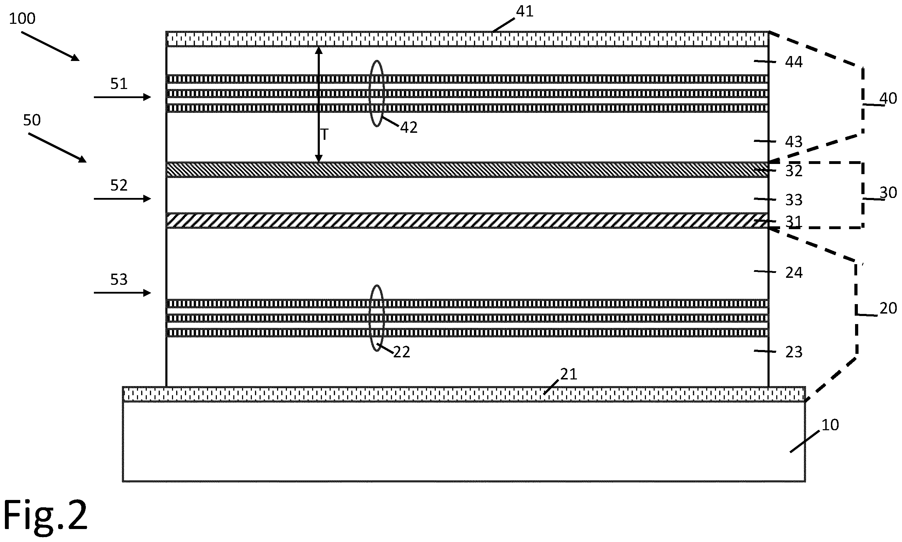

Figure 2 shows the layer stacks and the substrate 10 after a mesa 50 has been formed for instance by dry etching.

In the exemplary embodiment of Figure 2, the mesa 50 comprises a mesa section 51 of the upper layer stack 40, that has been formed by locally removing the upper layer stack 40, a mesa section 52 of the intermediate layer stack 30, that has been formed by locally removing the intermediate layer stack 30, and a mesa section 53 of the lower layer stack 20, that has been formed by locally removing an upper portion of the lower layer stack 20. In the exemplary embodiment of Figure 2, the upper portion includes layers 23 and 24 as well as the reflector 22.

Alternatively, the mesa 50 may only comprise a mesa section 51 of the upper layer stack 40 and a mesa section 52 of the intermediate layer stack 30, or the mesa 50 may only comprise a mesa section 51 of the upper layer stack 40 and an upper portion of the intermediate layer stack 30.

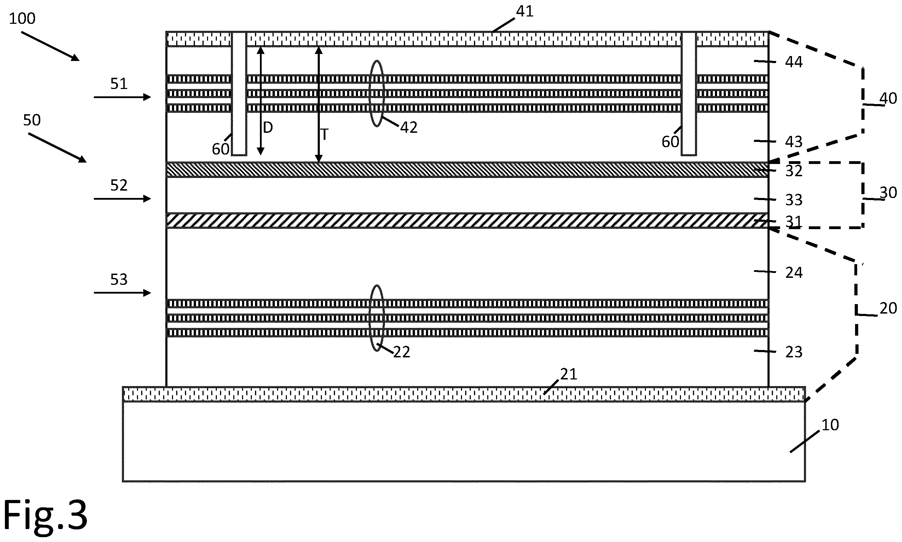

Figure 3 shows the mesa structure of Figure 2 after blind holes 60 have been etched into the mesa 50. The depth D of blind holes 60 is smaller than the thickness T of the upper layer stack 40. Therefore, the blind holes 60 are separated from the intermediate layer stack 30, in particular separated from the active layer 31 and the aperture layer 32. The holes 60 have preferably an opening between 1,5 and 10 $\mu$m.

In other words, since all active layers 31 and all aperture layers 32 of the radiation emitter 100 are exclusively located in the intermediate layer stack 30 and therefore below the upper layer stack 40, these layers 31 and 32 remain unaffected by blind holes: The blind holes 60 neither reach nor interact with the active layer(s) or the aperture layer(s).

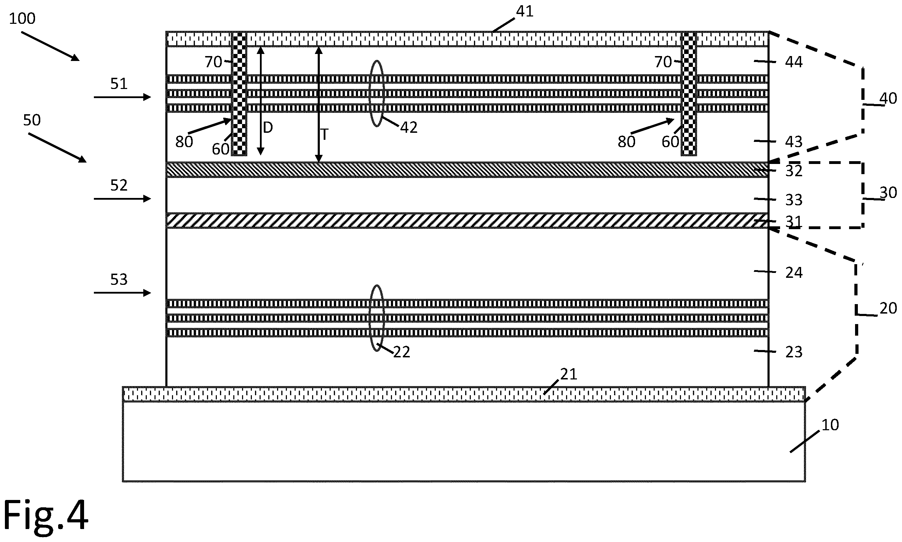

Figure 4 shows the mesa structure of Figure 3 after the blind holes 60 have been filled with a thermally conductive material 70. The thermally conductive material 70 may be an electrical isolator, for instance glass or a ceramic. If the blind holes 60 are filled with a thermally conductive and electrically isolating material, the filled blind holes 60 form thermal but not electrical bypasses 80. The thermal bypasses 80 may for instance allow heat that is generated in the active layer 31, to bypass the upper reflector 42 as shown in Figure 4.

Alternatively, the thermally conductive material 70 may also be electrically conductive. For instance, the thermally conductive material 70 may be a metal, a metal alloy, a conductive polymer, graphite, or a conductive oxide such as for instance ITO. If the blind holes 60 are filled with an electrically conductive material, the filled blind holes 60 form bypasses 80 that are thermally and electrically functional. The thermal and electrical bypasses 80 may for instance allow the electrical laser current and heat that is generated in the active layer 31, to bypass the upper reflector 42 as shown in Figure 4.

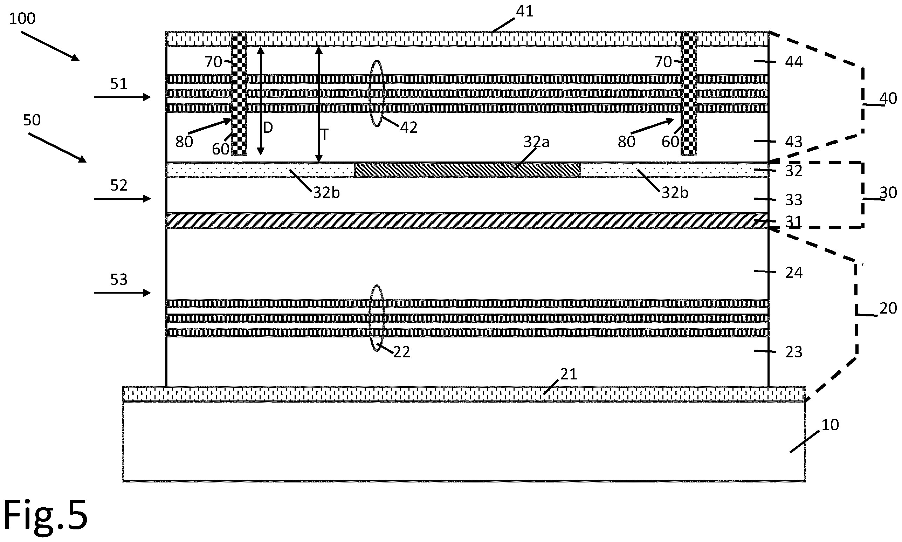

Figure 5 depicts the mesa structure of Figure 4 after the aperture layer 32 is subjected to a lateral oxidation step to provide an unoxidized aperture 32a that is laterally surrounded by oxidized material 32b. Since the blind holes 60 have been filled with the thermally conductive material 70 prior to the lateral oxidation step, the oxidation does not affect the inside surface of the blind holes 60, and for instance not the upper reflector 42 region adjacent to the blind holes 60.

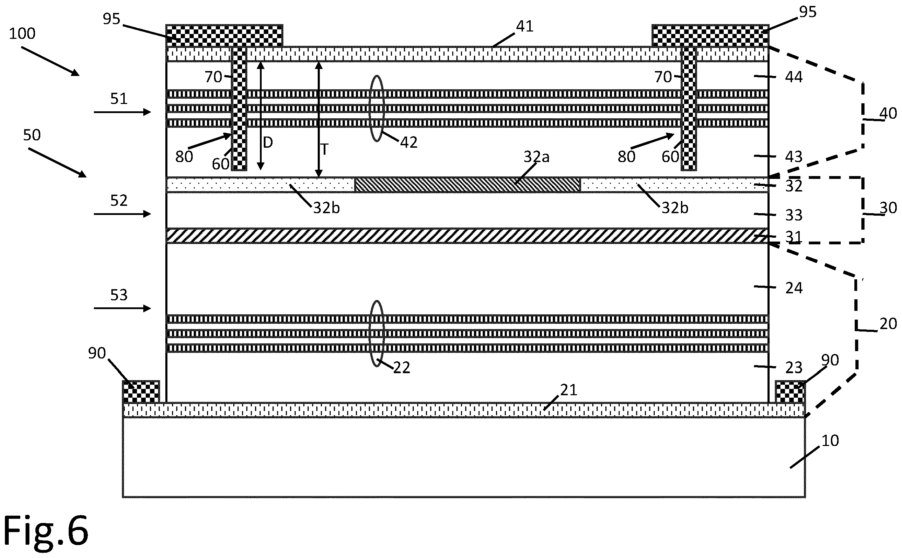

Figure 6 shows the mesa structure of Figure 5 after the lower contact layer 21 is provided with a lower electrically conductive contact material to form a lower electric contact 90 of the radiation emitter, and after the upper contact layer 41 is provided with an upper electrically conductive contact material to form an upper contact 95 of the radiation emitter. The structure shown in Figure 6 forms an exemplary embodiment of a radiation emitter 100, here for instance a VCSEL, according to the present invention.

The upper electrically conductive contact material and the lower electrically conductive contact material may be the same material or different materials. The lower electrically conductive contact material and/or the upper electrically conductive contact material can for instance be a metal, a metal alloy, a conductive polymer, or a conductive oxide such as for instance ITO.

The upper electrically conductive contact material and the thermally conductive material 70 may be different materials. For instance, the upper contact material may be a metal, a metal alloy, a conductive polymer, or a conductive oxide such as for instance ITO, and the thermally conductive material 70 may be glass or ceramic.

Alternatively, the upper electrically conductive contact material and the thermally conductive material 70 may be the same material, for instance a metal, a metal alloy, a conductive polymer, or a conductive oxide such as for instance ITO.

The upper and lower contact 90 and 95 are preferably fabricated in the same step, for instance the same metallization step. Alternatively, the contacts 90 and 95 can be fabricated in different steps, for instance different deposition steps using different materials.

In the exemplary embodiment of Figures 1-6, the step of filling the blind holes 60 with the thermally conductive material 70 and the step or steps of forming the upper and lower contact 90 and 95 are independent steps. More specifically, the step or steps of providing the contacts 90 and 95 is/are carried out after the step of filling the blind holes 60 with the thermally conductive material 70.

Figures 7-12 depict a second exemplary embodiment of a method of fabricating a radiation emitter according to the present invention.

Figure 7 shows a substrate 10 on which a lower layer stack 20, an intermediate layer stack 30 and an upper layer stack 40 have been fabricated. The layer stacks of Figure 7 may be identical to those described above in connection with the first embodiment of Figures 1-6.

Figure 8 shows the layer stacks and the substrate 10 of Figure 7 after etching the blind holes 60 into the upper layer stack 40. The depth D of blind holes 60 is smaller than the thickness T of the upper layer stack 40. Therefore, the blind holes 60 are separated from the intermediate layer stack 30 that is located beneath.

Figure 9 shows the layer stacks and the substrate 10 after a mesa 50 has been formed for instance by dry etching.

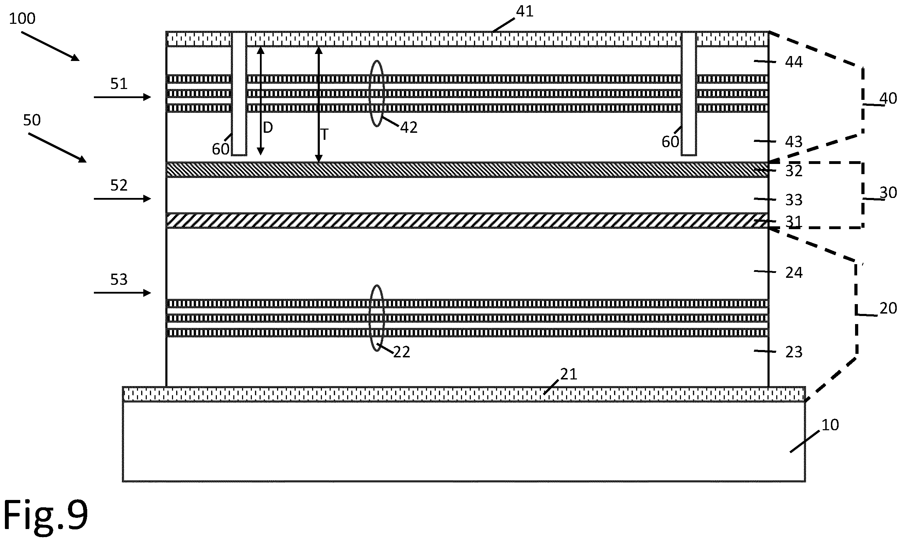

In the exemplary embodiment of Figure 9, the mesa 50 comprises a mesa section 51 of the upper layer stack 40, that has been formed by locally removing the upper layer stack 40, a mesa section 52 of the intermediate layer stack 30, that has been formed by locally removing the intermediate layer stack 30, and a mesa section 53 of the lower layer stack 20, that has been formed by locally removing an upper portion of the lower layer stack 20.

Alternatively, the mesa 50 may only comprise a mesa section 51 of the upper layer stack 40 and a mesa section 52 of the intermediate layer stack 30, or the mesa may only comprise a mesa section 51 of the upper layer stack 40 and an upper portion of the intermediate layer stack 30.

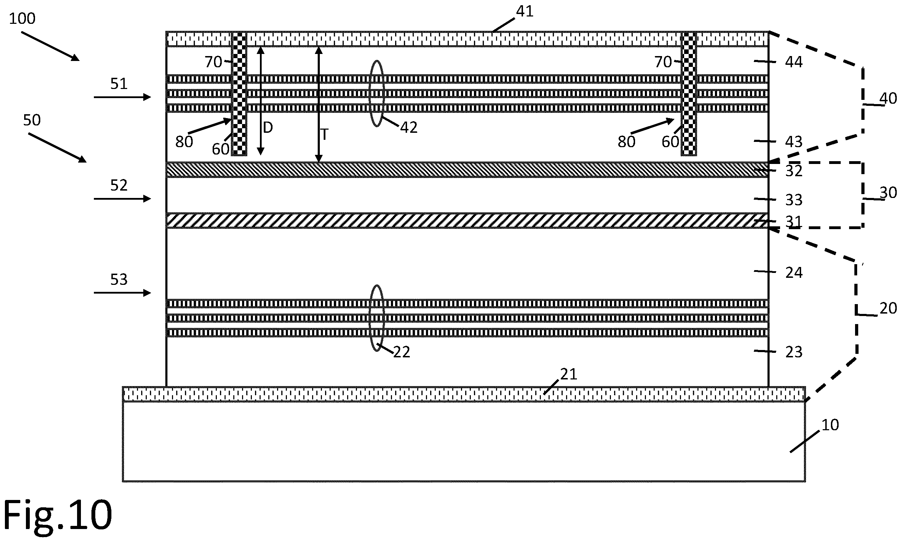

Figure 10 depicts the mesa structure of Figure 9 after the blind holes 60 have been filled with a thermally conductive material 70. The thermally conductive material 70 may be an electrical isolator for instance glass or a ceramic. If the blind holes 60 are filled with a thermally conductive electrical isolator, the filled blind holes 60 may for instance form thermal bypasses 80 for heat that is generated in the active layer 31. The heat may then bypass the upper reflector 42 as shown in Figure 9.

Alternatively, the thermally conductive material 70 may also be electrically conductive. For instance, the thermally conductive material 70 may be a metal, metal alloy or a conductive oxide such as for instance ITO. If the blind holes 60 are filled with an electrically conductive material, the filled blind holes 60 form bypasses 80 that are both thermally and an electrically functional. The bypasses 80 may for instance allow both the electrical laser current and the heat that is generated in the active layer 31, to bypass the upper reflector 42 as shown in Figure 10.

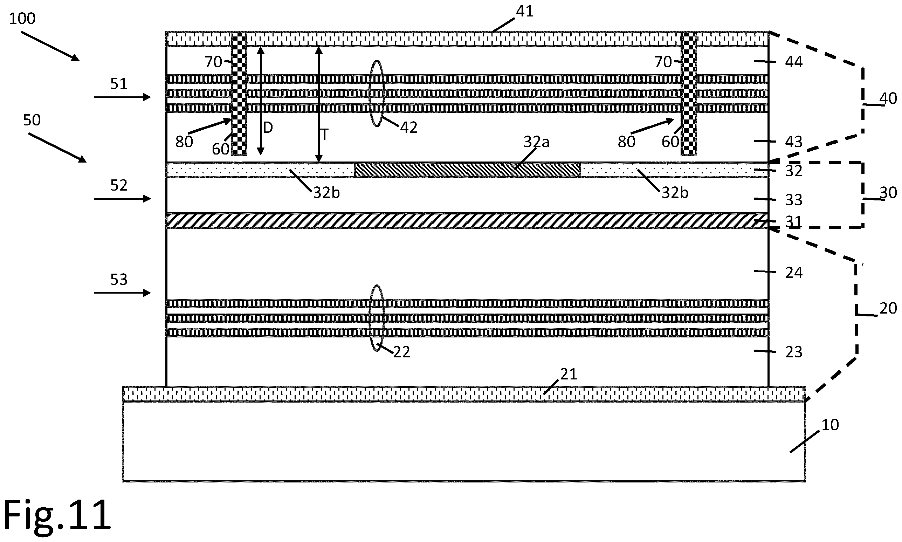

Figure 11 depicts the mesa structure of Figure 10 after the aperture layer 32 is subjected to a lateral oxidation step to provide an unoxidized aperture 32a that is laterally surrounded by oxidized material 32b. Since the blind holes 60 have been filled with the thermally conductive material before the lateral oxidation step is carried out, the oxidation does not affect the inside surface of the blind holes 60, and for instance not the upper reflector 42 region adjacent to the blind holes 60.

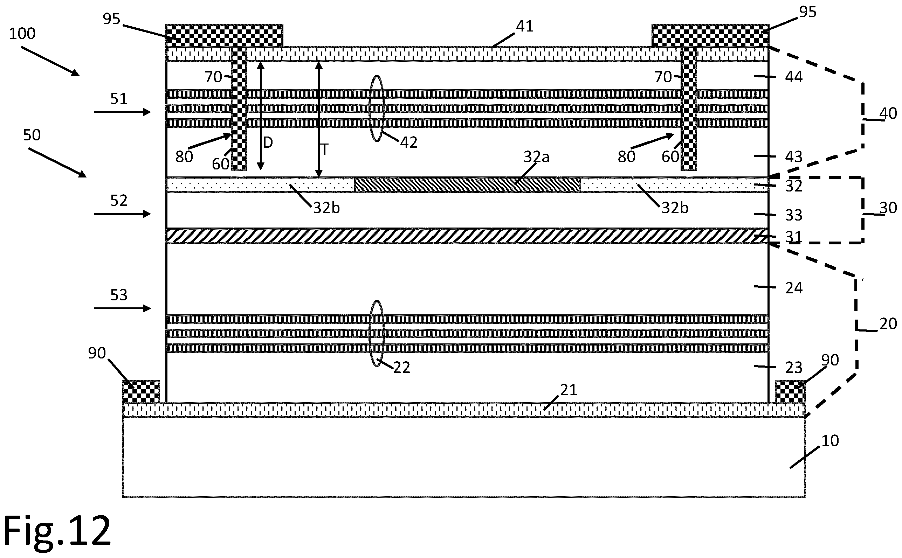

Figure 12 shows the mesa structure of Figure 11 after one or more contacting steps, for instance metallization steps, are carried out. During the contacting step or steps, the lower contact layer 21 is provided with a lower contact material to form a lower electric contact 90 of the radiation emitter, and after the upper contact layer 41 is provided with an upper contact material to form an upper contact 95 of the radiation emitter. The structure shown in Figure 12 forms an exemplary embodiment of a radiation emitter 100, here for instance a VCSEL, according to the present invention.

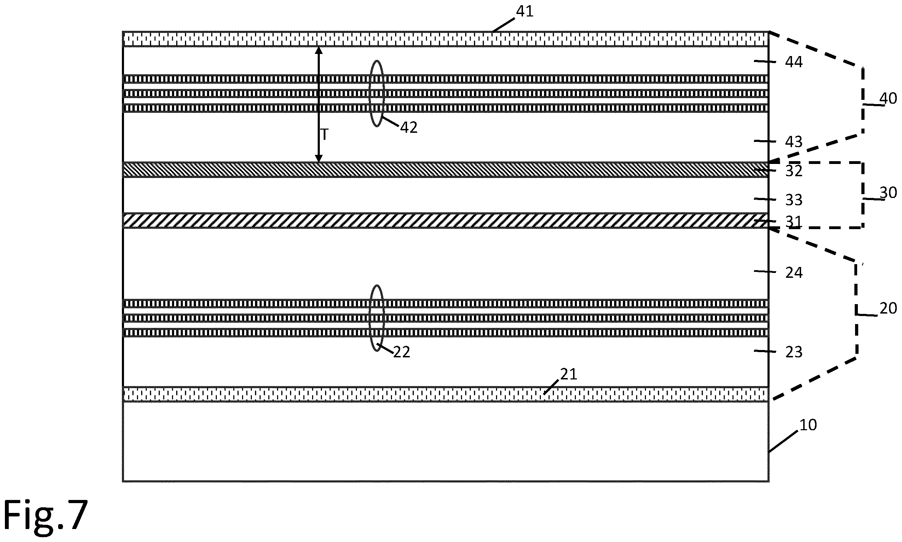

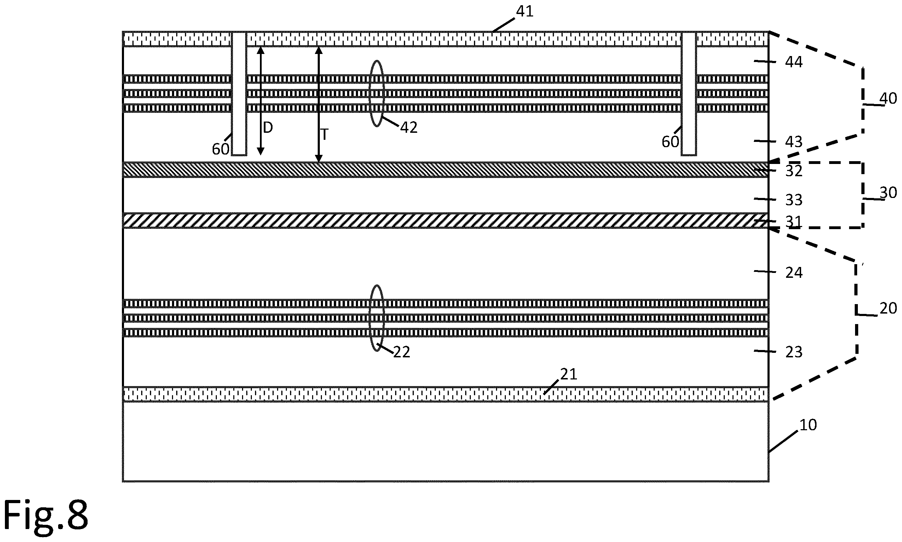

In the exemplary embodiment of Figures 7-12, the step of filling the blind holes 60 with the thermally conductive material 70 and the step or steps of providing the contact layers with the contact material are independent steps. The step or steps of providing the contact layers with the contact material(s) are carried out after the step of filling the blind holes 60 with the thermally conductive material 70.

The upper contact material and the thermally conductive material 70 may be different materials. For instance, the upper contact material may be a metal, a metal alloy, a conductive polymer, or a conductive oxide such as for instance ITO, and the thermally conductive material 70 may be a thermally conductive but electrically isolating material such as for instance glass or ceramic.

Alternatively, the upper contact material and the thermally conductive material 70 may both be electrically conductive. For instance, the upper contact material and the thermally conductive material 70 may be metals or metal alloys or a conductive oxide such as for instance ITO.

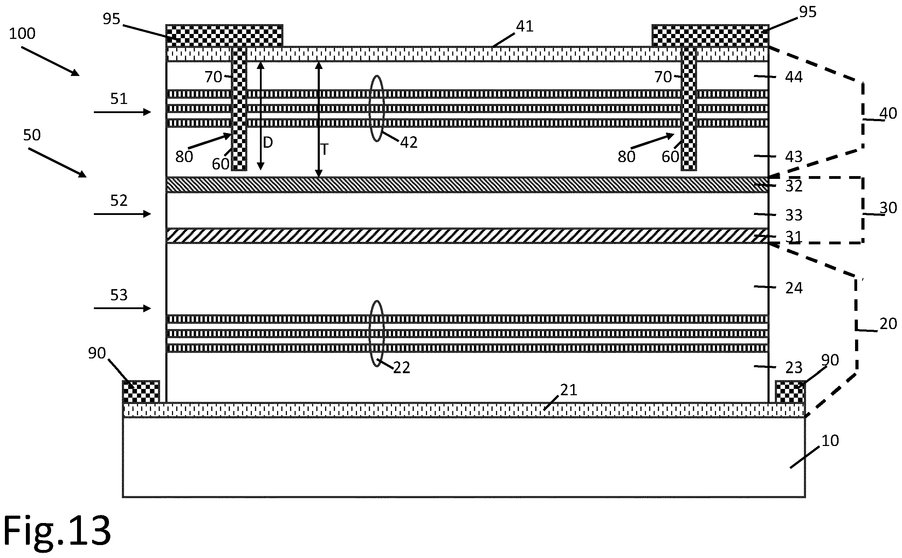

Figures 13-14 in connection with Figures 1-3 or 7-9 depict a third and fourth exemplary embodiment of a method of fabricating a radiation emitter according to the present invention.

Starting from the structure shown in Figure 3 or 9, the blind holes 60 are filled with a thermally conductive material 70. Then, the lower contact layer 21 is provided with a lower contact material to form the lower electric contact 90, and the upper contact layer 41 is provided with the upper contact material to form the upper contact 95 of the radiation emitter. Figure 13 shows the resulting structure before the oxidation step.

In Figure 13, the step of filling the blind holes 60 with the thermally conductive material 70 and the step(s) of providing the upper and lower contact layer with the upper and lower contact material may be independent steps. In this case, the step(s) of providing the contact layers with the contact material(s) are carried out after the step of filling the blind holes 60 with the thermally conductive material 70.

Alternatively, the step of providing the contact layers with the contact material(s) and the step of filling the blind holes 60 with the thermally conductive material 70 can be carried out in a single contacting step, for instance a single metallization step. In latter case, the contact material(s) and the filling material of the blind holes 60 may consist of the same electrically and thermally conductive material such as a metal, a metal alloy, a conductive polymer, or a conductive oxide such as for instance ITO.

After the blind holes 60 are filled and the upper and lower contact are completed, the lateral oxidation step is carried out to fabricate the aperture inside the aperture layer.

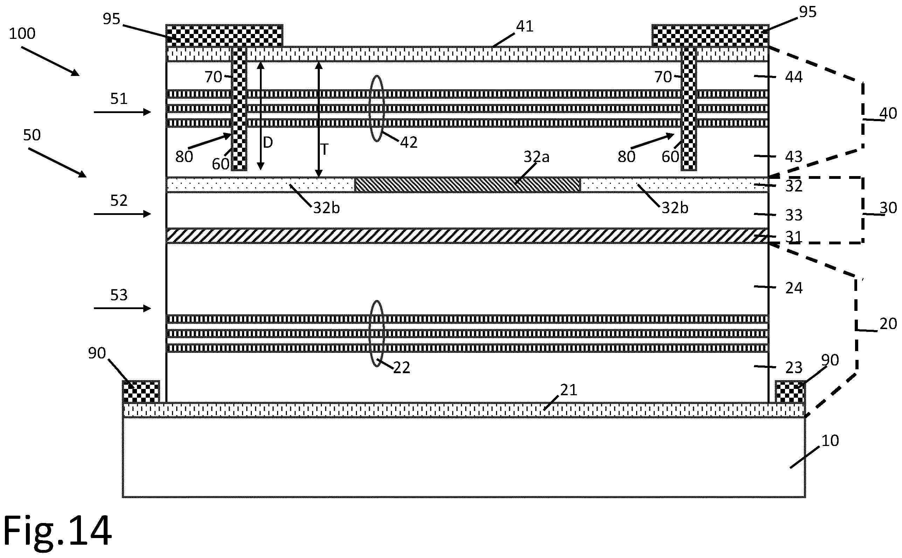

Figure 14 shows the resulting structure which forms an exemplary embodiment of a radiation emitter 100, here for instance a VCSEL, according to the present invention.

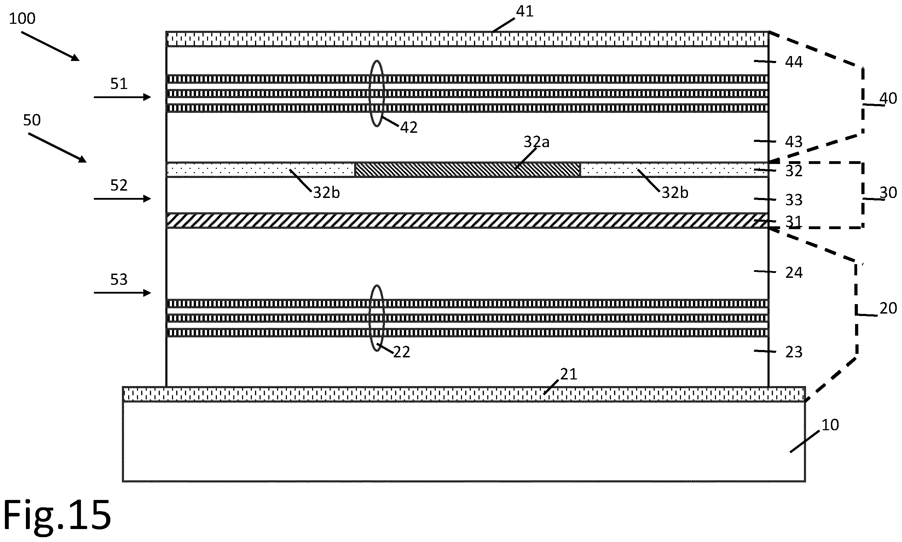

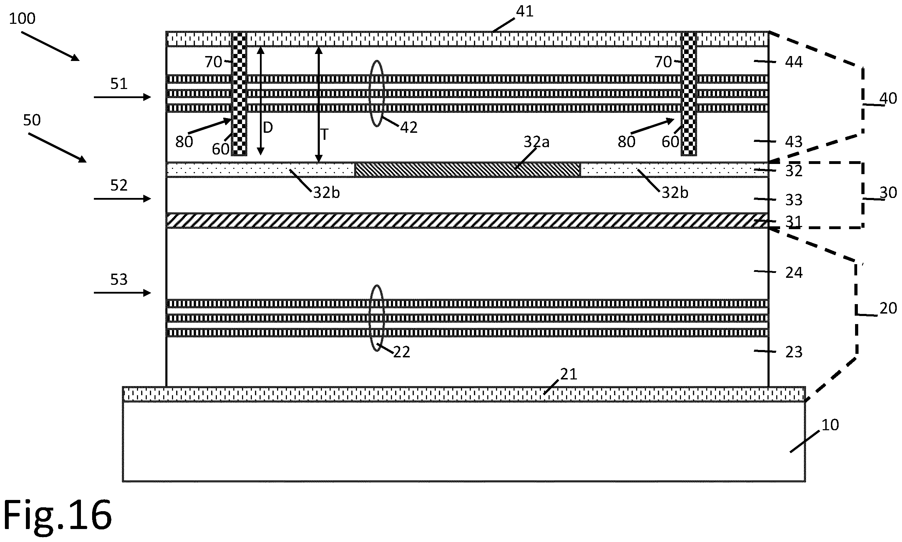

A fifth exemplary embodiment of a method of fabricating a radiation emitter according to the present invention can be obtained if the steps of forming the mesa 50 and oxidizing the aperture layer 32 (see Figure 15) are carried out prior to the step of etching the blind holes 60 and filling the blind holes with the thermally conducting material (see Figure 16).

In the exemplary embodiments described above, the thermal conductivity of the thermally conductive material preferably exceeds 200 W/(K m)at 300 K.

In the exemplary embodiments described above, the thermal conductivity of the thermally and electrical conductive material preferably exceeds 200 W/(K m) at 300 K, and the electrical conductivity of the thermally and electrical conductive material preferably exceeds $8 \cdot 10^6$ Sm$^{-1}$ ($8 \cdot 10^6/(\Omega \cdot m)$).

Suitable metals for forming the upper and lower contacts 90 and 95 and/or filling the blind holes are Gold, Silver, Platinum, Titanium, and Nickel.

Suitable metal alloys for forming the upper and lower contacts 90 and 95 and/or filling the blind holes preferably contain Gold, Silver, Platinum, Titanium, Nickel and/or Gold-Germanium alloys.

The exemplary embodiments described above in connection with Figures 1-16 refer to radiation emitters with two or more holes 60 that are - in a top-view - separated from both the exterior wall of the mesa 50 and the aperture 32a. In the same way, radiation emitters with a single hole can be fabricated.

In order to achieve an optimal distribution of heat and current density above and inside the aperture 32a during the operation of the emitter 100, the hole 60 (or at least one of the holes 60) is preferably ring-shaped. The ring-shaped hole 60 may have any closed contour such as a circular, elliptical, triangular, square, rectangular or polygonal contour. However, a circular or an elliptical contour are preferred.

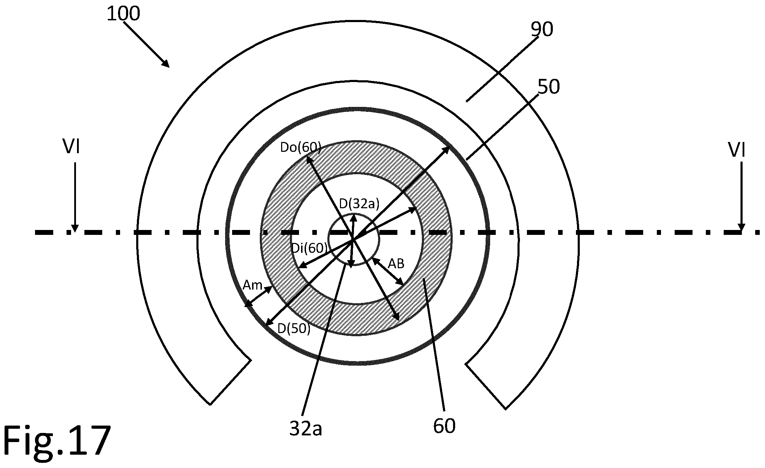

Figure 17 shows a top view of an exemplary embodiment of a radiation emitter 100 with a single circularly ring-shaped hole 60. The cross-section of this embodiment during and after fabrication (see line VI-VI) may be identical to the cross-sections shown in Figures 1-16, with the only difference being that the reference numeral 60 in these figures designates the same ring-shaped hole 60. The radiation emitter 100 of Figure 17 may be fabricated according to any of the methods discussed above in connection with Figures 1-16.

In order to achieve an optimal distribution of heat and current density above and inside the aperture 32a during the operation of the emitter 100, the emitter of Figure 17 preferably meets at least one of the following conditions:

$$2 \ \mu m \ < \ D(32a) \ < \ 20 \ \mu m$$

$$1,5 \ \mu m \ < \ AB \ < \ 20 \ \mu m$$

$$2 \ \mu m \ < \ Am \ < \ 20 \ \mu m$$

$$2 \ \mu m \ < \ (Do(60)-Di(60)) \ < \ 10 \mu m$$

wherein

- D(50) designates the outer diameter of the mesa 50,
- Do(60) designates the outer diameter of the circularly ring-shaped hole 60,
- Di(60) designates the inner diameter of the circularly ring-shaped hole 60,
- D(32a) designates the diameter of the aperture 32a,
- Am designates the distance between mesa edge and ring,
- (Do(60)-Di(60)) designates the radial width (thickness) of the elliptical ring and
- AB designates the distance between the aperture 32a and the inner side wall of the circularly ring-shaped hole 60 in the top view of Figure 17.

The radial thickness of the circularly ring-shaped hole 60 is preferably constant.

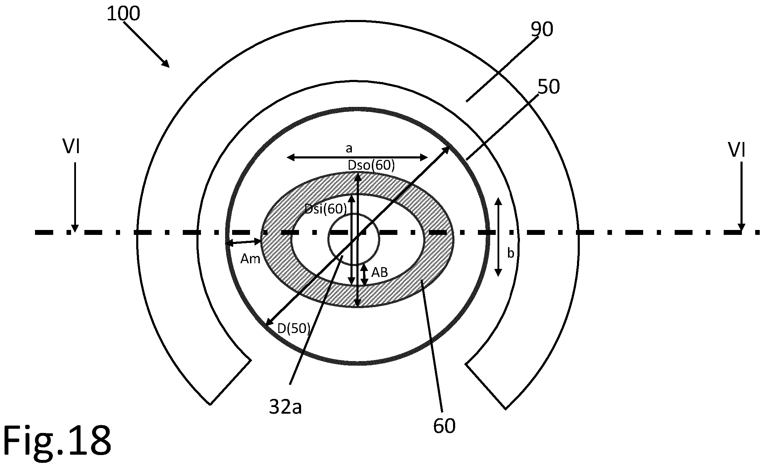

Figure 18 shows a top view of an exemplary embodiment of a radiation emitter 100 with a single elliptical ring-shaped hole 60. The cross-section of this embodiment during and after fabrication may be identical to the cross-sections shown in Figures 1-16, with the only difference being that the reference numeral 60 in these figures designates the same ring-shaped hole 60. The radiation emitter 100 of Figure 18 may be fabricated according to any of the methods discussed above in connection with Figures 1-16.

In order to achieve an optimal distribution of heat and current density above and inside the aperture 32a during the operation of the emitter 100, the emitter of Figure 18 preferably meets one or more of the following conditions:

$$2 \ \mu m \ < \ D(32a) \ < \ 20 \ \mu m$$

$$1,5 \ \mu m \ < \ AB \ < \ 20 \ \mu m$$

$$2 \ \mu m \ < \ Am \ < \ 20 \ \mu m$$

$$2 \ \mu m \ < \ (Dso(60)-Dsi(60)) \ < \ 10 \mu m$$

wherein

- D(50) designates the outer diameter of the mesa 50,

- Dso(60) designates the outer diameter of the elliptically ring-shaped hole 60 with respect to the semi-minor axis,
- Dsi(60) designates the inner diameter of the elliptically ring-shaped hole 60 with respect to the semi-minor axis,
- a and b designate the width and height of the elliptically ring-shaped hole 60 with respect to its inner wall,
- D(32a) designates the diameter of the aperture 32a,
- Am designates the minimal distance between mesa edge and ring,
- (Dso(60)-Dsi(60)) designates the radial width (thickness) of the elliptical ring and
- AB designates the minimal distance between the aperture 32a and the inner side wall of the elliptically ring-shaped hole 60 in the top view of Figure 18.

The radial thickness of the elliptically ring-shaped hole 60 is preferably constant.

Regarding all embodiments described above with reference to Figures 1-18, the electrical specific resistance of the layer stack that comprises all layers above the aperture 32a (in case of more than one aperture, the uppermost aperture) should be below a maximum value of $10^5$ $\Omega$cm. An electrical resistance below this value usually results in a first portion of at least 20% of the total electrical current being guided through the upper reflector forming a first electrical "path", and a second portion of maximal 80% of the total electrical current being bypassed by the hole or holes 60 that form the so-called bypass.

The electrical specific resistance of the upper reflector 42 is preferably below $10^5$ $\Omega$cm to optimize the current flow.

The upper reflector 42 preferably consists of any of the materials of the following material systems:

- GaAs-based material systems, like GaAs, AlGaAs, GaInAsP, GaInN, ...
- InP-based material systems, like InP, InGaAs, InGaAsP, InGaAlAsP, ...
- GaN-based material systems, like GaN, AlGaN, InGaN, InGaAlN, ...

The n- or p-doping level in the upper reflector 42 is preferably between $10^{17}$ cm$^{-3}$ and $10^{19}$ cm$^{-3}$.

In the drawings and specification, there have been disclosed a plurality of embodiments of the present invention. The applicant would like to emphasize that each feature of each embodiment may be combined with or added to any other of the embodiments in order to modify the respective embodiment and create additional embodiments. These additional embodiments form a part of the present disclosure and, therefore, the applicant may file further patent claims regarding these additional embodiments at a later stage of the prosecution.

Further, the applicant would like to emphasize that each feature of each of the following dependent claims may be combined with any of the present independent claims as well as with any other (one ore more) of the present dependent claims (regardless of the present claim structure). Therefore, the applicant may direct further patent claims towards other claim combinations at a later stage of the prosecution.

**Claims**

1. Method of fabricating a radiation emitter (100) comprising the steps of

   fabricating a lower layer stack (20) on top of a substrate (10), the lower layer stack (20) comprising a lower contact layer (21) and at least one lower reflector (22), the lower reflector (22) being electrically conductive and subjected to electrical current during operation,
   fabricating an intermediate layer stack (30) on top of the lower layer stack (20), the intermediate layer stack (30) comprising at least one active layer (31) and at least one aperture layer (32),
   fabricating an upper layer stack (40) on top of the intermediate layer stack (30), the upper layer stack (40) comprising at least one electrically conductive upper reflector (42) and an upper contact layer (41) above the at least one upper reflector (42) and
   forming a mesa that at least comprises a mesa section of the upper layer stack (40), by locally removing at least the upper layer stack (40),
   **characterized in that**
   after or before forming the mesa, at least one blind hole (60) having a depth (D) smaller than the thickness (T) of the upper layer stack (40) is etched inside the mesa section of the upper layer stack (40), and
   the at least one blind hole (60) is filled with a thermally conductive material (70).

2. Method of claim 1 wherein
   the thermally conductive material (70) is also electrically conductive.

**3.** Method of any of the preceding claims,
wherein the at least one hole is ring-shaped.

**4.** Method of claim 2 or 3,

wherein the upper reflector provides a first electrical current path,
wherein the filled blind hole or holes provide a second electrical current path that bypasses the first current path, and
wherein the portion of the electrical current that flows through the first path, is preferably at least 20% of the total electrical current that flows through the radiation emitter during its operation.

**5.** Method of any of the preceding claims wherein
the at least one hole is circularly or elliptically ring-shaped.

**6.** Method of any of the preceding claims wherein
after etching the mesa

the lower contact layer (21) is provided with a lower contact material to form a lower electric contact (90) of the radiation emitter (100), and
the upper contact layer (41) is provided with an upper contact material to form an upper electric contact (95) of the radiation emitter (100).

**7.** Method of claim 6 wherein

the step of filling the at least one blind hole (60) with the thermally conductive material (70) and the step of providing the upper contact layer (41) with the upper contact material are independent steps,
wherein the step of providing the upper contact layer (41) with the upper contact material is carried out after the step of filling the at least one blind hole (60) with the thermally conductive material (70).

**8.** Method of any of the preceding claims wherein
the step of filling the at least one blind hole (60) with the thermally conductive material (70) and the step of providing the upper contact layer (41) with the upper contact material are carried out in a single contacting step.

**9.** Method of any of the preceding claims wherein
after forming the mesa, the at least one aperture layer (32) is subjected to a lateral oxidation step to provide an unoxidized aperture (32a) that is laterally surrounded by oxidized material (32b).

**10.** Method of claim 9 wherein
the at least one blind hole (60) is etched and filled with the thermally conductive material (70) after forming the mesa and before laterally oxidizing the aperture layer (32).

**11.** Radiation emitter comprising a mesa (50) that includes at least a mesa section of an upper layer stack (40),

wherein the upper layer stack (40) is located above an intermediate layer stack (30) and comprises an upper contact layer (41) and at least one electrically conductive upper reflector (42),
wherein the intermediate layer stack is located above a lower layer stack (20) and comprises at least one active layer (31) and at least one aperture layer (32), and
wherein the lower layer stack (20) is located on a substrate (10) and comprises a lower contact layer (21) and at least one lower reflector (22), the lower reflector (22) being electrically conductive and subjected to electrical current during operation,
**characterized in that**
at least one blind hole (60) having a depth (D) smaller than the thickness (T) of the upper layer stack (40) is located inside the upper layer stack (40),
wherein the at least one blind hole (60) is filled with a thermally conductive material (70).

**12.** Radiation emitter of claim 11,
wherein the thermally conductive material (70) is also electrically conductive.

13. Radiation emitter of any of the preceding claims,

   wherein the upper reflector provides a first electrical current path, and
   wherein the filled blind hole or holes provide a second electrical current path that bypasses the first current path.

14. Method of claim 12 or 13,
   wherein the at least one hole is ring-shaped and provides a ring-shaped electrical current path that surrounds an electrical current path that is provided by the upper reflector.

15. Method of any of the preceding claims wherein
   the at least one hole is circularly or elliptically ring-shaped hole.

Fig.1

Fig.2

EP 4 528 946 A1

Fig.3

EP 4 528 946 A1

Fig.4

EP 4 528 946 A1

Fig.5

EP 4 528 946 A1

Fig.6

EP 4 528 946 A1

Fig.7

EP 4 528 946 A1

Fig.8

Fig.9

Fig.10

Fig.11

EP 4 528 946 A1

Fig.12

Fig.13

Fig.14

EP 4 528 946 A1

Fig.15

EP 4 528 946 A1

Fig.16

Fig.17

Fig.18

EP 4 528 946 A1

Europäisches
Patentamt

European
Patent Office

Office européen
des brevets

# EUROPEAN SEARCH REPORT

**Application Number**

EP 24 18 6974

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 115 133 400 A (WIN SEMICONDUCTORS CORP) 30 September 2022 (2022-09-30) | 1-3, 5-12,14, 15 | INV. H01S5/183 H01S5/024 |
| Y | * paragraphs [0054] - [0086]; figures 1-4 * | 4,13 | H01S5/042 |
| | ----- | | |
| X | EP 0 715 378 A1 (MOTOROLA INC [US]) 5 June 1996 (1996-06-05) | 1-3,5-8, 11,12, 14,15 | |
| Y | * column 2, line 10 - column 8, line 8; figures 1-5 * | 4,13 | |
| | ----- | | |
| X | US 2005/089075 A1 (BABA TOSHIHIKO [JP] ET AL) 28 April 2005 (2005-04-28) * paragraphs [0015] - [0027], [0063] - [0073], [0107] - [0114]; figures 1,8 * | 1,6,7,9, 11 | |
| | ----- | | |
| Y | US 2022/059997 A1 (LARISCH GUNTER [DE] ET AL) 24 February 2022 (2022-02-24) * paragraphs [0044] - [0049], [0055] - [0073]; figures 1-7 * | 4,13 | |
| | ----- | | **TECHNICAL FIELDS SEARCHED (IPC)** |
| | | | H01S |

The present search report has been drawn up for all claims

| Place of search | Date of completion of the search | Examiner |
|---|---|---|
| Munich | 19 December 2024 | Laenen, Robert |

EPO FORM 1503 03.82 (P04C01)

## ANNEX TO THE EUROPEAN SEARCH REPORT
## ON EUROPEAN PATENT APPLICATION NO.

EP 24 18 6974

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2024

| Patent document cited in search report | | Publication date | Patent family member(s) | | Publication date |
|---|---|---|---|---|---|
| CN 115133400 | A | 30-09-2022 | CN | 115133400 A | 30-09-2022 |
| | | | TW | 202239092 A | 01-10-2022 |
| | | | US | 2022311212 A1 | 29-09-2022 |
| EP 0715378 | A1 | 05-06-1996 | DE | 69512870 T2 | 31-05-2000 |
| | | | EP | 0715378 A1 | 05-06-1996 |
| | | | JP | H08222805 A | 30-08-1996 |
| | | | KR | 960019871 A | 17-06-1996 |
| | | | TW | 353821 B | 01-03-1999 |
| | | | US | 5468656 A | 21-11-1995 |
| US 2005089075 | A1 | 28-04-2005 | CN | 1627576 A | 15-06-2005 |
| | | | EP | 1528647 A2 | 04-05-2005 |
| | | | JP | 4641736 B2 | 02-03-2011 |
| | | | JP | 2005159272 A | 16-06-2005 |
| | | | KR | 20050040772 A | 03-05-2005 |
| | | | US | 2005089075 A1 | 28-04-2005 |
| | | | US | 2007202622 A1 | 30-08-2007 |
| US 2022059997 | A1 | 24-02-2022 | CN | 113594855 A | 02-11-2021 |
| | | | EP | 3961829 A1 | 02-03-2022 |
| | | | EP | 3961830 A1 | 02-03-2022 |
| | | | US | 2022059991 A1 | 24-02-2022 |
| | | | US | 2022059997 A1 | 24-02-2022 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100215070 A1
- US 2022311212 A1
- US 2020274328 A1

- EP 3961829 A1
- EP 3961830 A1
- EP 4007092 B1

**Non-patent literature cited in the description**

- **LARISCH et al.** *Optics Express*, 2020, vol. 28, 6